Europäisches Patentamt

**European Patent Office**

**Office européen des brevets**

(11) Numéro de publication: **0 333 573 B1**

(12) # FASCICULE DE BREVET EUROPEEN

(45) Date de publication de fascicule du brevet: **12.01.94** (51) Int. Cl.5: **G02F 1/00**, C30B 29/54

(21) Numéro de dépôt: **89400690.7**

(22) Date de dépôt: **13.03.89**

(54) **Procédé d'obtention d'un matériau organique polycristallin ayant notamment des proprietés électrooptiques.**

(30) Priorité: **14.03.88 FR 8803285**

(43) Date de publication de la demande:
**20.09.89 Bulletin 89/38**

(45) Mention de la délivrance du brevet:
**12.01.94 Bulletin 94/02**

(84) Etats contractants désignés:
**DE GB IT NL SE**

(56) Documents cités:
**US-A- 4 044 082**

**SOVIET JOURNAL OF OUANTUM ELECTRO-NICS, vol. 16, no. 2, février 1986, pages 272-274, American Institute of Physics, Woodbury, New York, US; R.V. KOCHIKYAN et al.: "Determination of the frequency interval of phase-matched nonlinear conversion in powders of various molecular crystals"**

**PATENT ABSTRACTS OF JAPAN, vol. 12, no. 156 (P-701)[3003], 13 mai 1988; & JP-A-62 272 231**

(73) Titulaire: **FRANCE TELECOM**
**6, Place d'Alleray**
**F-75015 Paris(FR)**

(72) Inventeur: **Flicstein, Jean**
**17 rue Meslay**
**F-75003 Paris(FR)**
Inventeur: **Morin, Denise**
**44 rue de Coulmiers**
**F-94130 Nogent sur Marne(FR)**

(74) Mandataire: **Mongrédien, André et al**
**c/o BREVATOME**
**25, rue de Ponthieu**
**F-75008 Paris (FR)**

EP 0 333 573 B1

OPTICS COMMUNICATIONS, vol. 29, no. 2, mai 1979, pages 243-246, Amsterdam, NL; C. CASSIDY et al.: "Nonlinear optical properties of urea"

K.D. Singer, S.L. Lalama, J.E. Sohn et R.D. Small, dans "Nonlinear Optical Properties of Organic Molecules and Crystals", vol. 1 (1987), D. Chemla et J. Zyss, Eds., AT&T Labs, pp. 437-467.

J.M. Halbout et C.L. Tang, dans "Nonlinear Optical Properties of Organic Molecules and Crystals", vol. 1 (1987), D. Chemla et J. Zyss, Eds., AT&T Labs, pp. 388-389.

PATENT ABSTRACTS OF JAPAN, vol. 11, no. 8 (C-396), 2455 du 9 janvier 1987 (JP-A-61 186 207)

M.M. Shabana et R.V. Jones, Proc. IEEE 54 (1966), pp. 85-86.

Jack C. Burfoot et George W. Taylor, "Polar Dielectrics and their Applications", Mackmillan Press Ltd., New York (1979), pp. 303-316.

## Description

La présente invention se rapporte à un procédé d'obtention d'un matériau organique polycristallin, solide, à grains monocristallins orientés. Elle s'applique plus spécialement dans le domaine de l'optique non linéaire pour la conversion de fréquences optiques (obtention d'un rayonnement optique à partir de deux rayonnements de fréquences différentes) pour la modulation électrooptique d'un rayonnement lumineux (modulation de la phase ou de la polarisation de la lumière). En particulier, les matériaux obtenus peuvent être utilisés comme déphaseurs dans des interféromètres, comme polariseurs dans des dispositifs de visualisation, comme commutateurs (Q switch en terminologie anglo-saxonne) dans les lasers pulsés, ou comme guides de lumière en optique intégrée.

De façon générale, le procédé selon l'invention permet la croissance polycristalline de tout composé organique comportant des molécules présentant un moment dipolaire selon un axe de symétrie couramment appelé axe polaire.

Dans les modulateurs électrooptiques connus, on utilise actuellement des monocristaux de matériaux minéraux tels que le diphosphate de potassium (KDP), le niobate de lithium, le titanate de lanthane, de plomb et de zirconium (PLZT).

Ces matériaux minéraux présentent l'inconvénient de manquer d'efficacité, ce qui oblige à les employer sous de fortes épaisseurs. En outre, l'effet électrooptique de ces matériaux, dû à leur ferroélectricité, résulte d'une variation de la maille cristalline entraînant de fortes contraintes à l'intérieur des cristaux provoquant généralement un décollement des électrodes nécessaires à la modulation ainsi qu'une usure prématurée du matériau.

Par ailleurs, ces minéraux ont tendance à voir leur indice de réfraction changer au cours du temps à cause de la photoréfraction, entraînant une dérive en tension possible des dispositifs électrooptiques comportant ces matériaux.

L'élaboration de ces monocristaux de matériaux minéraux nécessite en outre des températures élevées et par conséquent une consommation d'énergie importante ainsi que des contraintes de fabrication importantes.

Aussi, depuis quelques années, les recherches ont porté sur la fabrication de monocristaux de molécules organiques. Ces monocristaux ont l'avantage de présenter une efficacité améliorée par rapport aux monocristaux minéraux, de pouvoir être fabriqués à température relativement basse, de présenter une bande passante large, des fenêtres de transparence situées dans le domaine du visible et de l'infrarouge proche.

Les propriétés électrooptiques des monocristaux organiques sont dues à des déplacements électroniques et non à des variations de la maille cristalline comme pour les cristaux minéraux, ce qui leur assure une meilleure tenue mécanique et une durée de vie plus élevée.

Pour de plus amples détails sur les propriétés électrooptiques de certains matériaux organiques, on peut se référer à l'article de K.D. SINGER et al. paru dans Non Linear Optical Properties of Organic Molecules and Crystals, vol.1 (1987), pp 437-467, D. Chemla et J. Zyss, Eds., AT&T Labs.

Malheureusement, il est actuellement très difficile de fabriquer des monocristaux de matériau organique de grande taille utilisables dans l'industrie. Les procédés actuellement connus d'élaboration de monocristaux de matériau organique (croissance selon la technique Bridgmann ou à partir d'une vapeur) sont difficiles à mettre en oeuvre et surtout peu reproductibles.

La difficulté d'obtenir des cristaux organiques de grande taille est notamment décrite dans l'article de SINGER cité précédemment.

La difficulté d'obtenir des cristaux de grande dimension d'un matériau organique n'est pas une spécificité des matériaux présentant des propriétés électrooptiques. En effet, tout monocristal de grande taille d'un matériau organique est difficile à élaborer.

Enfin, il n'existe pas, actuellement dans le commerce, de dispositifs électro-optiques fiables à matériau organique.

La présente invention a justement pour objet un procédé d'obtention d'un matériau organique utilisable notamment dans le domaine de l'optique non linéaire et permettant de remédier aux différents inconvénients donnés ci-dessus.

De façon plus précise, l'invention a pour objet un procédé d'obtention d'un matériau polycristallin comportant des grains monocristallins, orientés selon une même direction, ce matériau étant formé d'un composé organique moléculaire dont les molécules présentent au moins un dipôle orienté selon cette direction, ce procédé comprenant les étapes suivantes :

a) - choix d'un composé organique dont les molécules présentent au moins un axe de symétrie selon cette direction,

b) - préparation d'une poudre fine dudit composé ayant une granulométrie inférieure au micromètre,

c) - séchage sous vide de la poudre à une température inférieure à la température à laquelle la tension de vapeur dudit composé induit une détérioration sensible dudit vide,

d) - compression selon cette direction, sous vide, de la poudre sèche pour former des grains monocristallins allongés et orientés selon la direction de compression.

Ce procédé d'obtention est relativement simple et ne comporte aucune étape critique. En outre, il permet la réalisation de barreaux ou de pastilles organiques de grande dimension.

Les inventeurs ont trouvé qu'un matériau polycristallin orienté d'un composé organique moléculaire présentant des propriétés en optique non linéaire pouvait remplacer les matériaux minéraux actuellement utilisés pour la modulation électrooptique et que les réponses électrooptiques de ces matériaux étaient comparables à celles des meilleures réponses des matériaux inorganiques. En effet, si le matériau polycristallin est monophasé, il n'y aura pas de diffusion de la lumière, mais simplement des pertes ou atténuations de celle-ci provenant de la réfraction et de la réflexion de la lumière par les pores du matériau du fait de la différence d'indice de réfraction pore-grain monocristallin, de la réflexion et de la réfraction de la lumière dues à l'anisotropie des grains et éventuellement de l'absorption optique dans le domaine de longueur d'onde utilisée.

A cet effet, les joints de grain doivent être le moins gênants possible pour la transmission de la lumière. Aussi, on utilise avantageusement des grains dont la plus petite dimension est du même ordre de grandeur que la longueur d'onde de la lumière à moduler, voire au moins égale à cette longueur d'onde.

Si le même matériau doit servir pour moduler différentes longueurs d'onde, la plus petite dimension doit être voisine de la longueur d'onde maximale à transmettre. A titre d'exemple pour l'hexaméthylène-tétramine (HMT), 800 nm est la longueur d'onde maximale transmise ; aussi, la plus petite dimension des grains monocristallins doit-elle être voisine de 800 nm, pour assurer une transparence à une longueur d'onde inférieure, par exemple 450 nm pour HMT.

Avec le procédé selon l'invention, il est possible d'obtenir en particulier des barreaux organiques polycristallins ayant un coefficient de transmission lumineuse de 89,8% dans le visible.

Afin d'améliorer l'orientation des grains monocristallins, le procédé selon l'invention comprend avantageusement une étape de chauffage sous vide de la poudre sèche.

Les températures de chauffage et de séchage de la poudre sont fonction du composé organique et en particulier de sa tension de vapeur.

L'étape de chauffage peut être réalisée simultanément à l'étape de compression uniaxiale sous vide ou bien avant cette étape de compression. Dans ce dernier cas, on obtient une sublimation de la poudre puis le dépôt de petits cristaux sur le piston servant à la compression de la poudre, petits cristaux qui vont ensuite servir de germes pour la croissance de plus gros grains monocristallins lors de l'étape de compression uniaxiale.

La faible perte ou atténuation de l'intensité lumineuse traversant le matériau polycristallin est directement liée à la taille et à la forme des grains élémentaires de la poudre. Ces derniers jouent un rôle déterminant sur l'obtention d'un matériau ayant une densification proche de la valeur théorique représentée par le monocristal de même composition. Aussi, la poudre doit présenter une densité volumique aussi faible que possible et les grains élémentaires doivent avoir une taille sous-micronique et par exemple allant de 500 à 800 nm.

L'utilisation de particules agglomérées, c'est-à-dire peu dispersées affectent la frittabilité du matériau, et conduit à une distribution de la porosité non uniforme. Aussi, le séchage de la poudre doit être efficace, car l'humidité de cette dernière maintient un état d'agrégation néfaste à la frittabilité. Une teneur en eau résiduelle inférieure à 10 ppm est souhaitable.

Par ailleurs, la poudre doit présenter une grande pureté, d'où la nécessité de travailler sous vide afin d'éviter toute pollution par l'atmosphère ambiante.

La première idée qui vient à l'esprit pour réduire un composé en poudre est de le broyer mécaniquement. Malheureusement, ce procédé ne permet pas actuellement, d'obtenir une poudre ayant une granulométrie inférieure au micromètre. En outre, le broyage se faisant à l'air libre, en milieu humide, la poudre obtenue est trop polluée.

Aussi, selon l'invention, la poudre est obtenue soit par atomisation, soit par lyophilisation. Cette dernière est plus particulièrement adaptée au composé organique à tension de vapeur faible. L'atomisation et la lyophilisation consistent à dissoudre le composé organique dans un solvant faiblement ou moyennement polaire à une concentration allant de 2 à 40% en poids du composé et par exemple de 10 à 30% en poids.

Le solvant utilisé peut être un solvant aqueux ou non aqueux tel que les alcools (méthanol, éthanol, pentanol, alcool amylique, glycérol), le chloroforme, l'acétone, le tétrachlorure de carbone ou tout autre solvant organique moyennement polaire à condition que ce dernier présente une tension de vapeur élevée

4

aux températures et pressions utilisées en vue de son élimination ultérieure. En outre, l'étape de lyophilisation comportant une étape de congélation, le solvant utilisé pour la lyophilisation doit pouvoir être congelé facilement. Aussi, ce dernier présente par exemple une température de congélation relativement faible et en particulier non inférieure à la température de l'azote liquide.

Pour obtenir une bonne dispersion de la poudre obtenue, on utilise avantageusement un mélange eutectique du solvant et du composé organique. Ce mélange eutectique est ensuite pulvérisé à l'aide d'une buse dont le diamètre des gouttes obtenues va de 0,5 à 2 micromètres. L'utilisation d'une buse plus petite peut conduire à une perte trop importante du composé, le brouillard obtenu ayant tendance à voler partout et en particulier en dehors du récipient devant servir à récupérer la poudre. Par ailleurs, un diamètre de buse supérieur ne permet pas l'obtention d'une poudre de granulométrie inférieure au micromètre.

Un autre facteur intervenant dans l'obtention d'une poudre extrêmement fine par atomisation est le débit de la pulvérisation de la solution organique. Aussi, le débit du gaz comprimé servant à la pulvérisation de la solution est avantageusement compris entre 500 et 600 l/h.

Dans le cas de l'atomisation, la pulvérisation de la solution se fait à chaud, c'est-à-dire à une température permettant l'évaporation du solvant. Cette température dépend donc du solvant mais aussi du composé organique. L'utilisation d'un solvant organique présente l'avantage d'abaisser la température à laquelle les composés sont exposés. En revanche, lors de l'atomisation, étape réalisée à chaud, il est nécessaire d'utiliser un gaz inerte (azote, gaz rare) afin d'éviter l'inflammation du solvant organique.

Dans le cas de l'eau comme solvant, la pulvérisation se fait à une température allant de 70 à 150°C. Avec de l'éthanol comme solvant, le chauffage de la solution à pulvériser peut aller de 50 à 70°C.

Le procédé selon l'invention permet en particulier l'obtention de matériaux polycristallins ayant des propriétés de propagation non linéaire de la lumière. Cette non linéarité optique est due à un système d'électrons π délocalisés ainsi qu'à la présence d'une structure cristalline non centro-symétrique.

Les composés organiques moléculaires présentent une réponse électrooptique de l'ordre de la picoseconde au lieu de l'ordre de la microseconde pour les composés minéraux utilisés en optique non linéaire. Ceci est notamment dû au mécanisme basé sur le déplacement du cortège électronique. Ainsi, les matériaux organiques selon l'invention peuvent être utilisés dans des circuits électrooptiques ultra-rapides. De plus, aucune dérive en tension des dispositifs électrooptiques comportant des monocristaux de matériaux organiques n'a été remarquée.

En outre, les composés organiques ont des susceptibilités moléculaires larges. Avantageusement, on intensifie la délocalisation des électrons π par adjonction de groupements à transfert de charge ou groupements polaires. En outre, la présence d'un dipôle selon au moins un axe de symétrie de la molécule ou mieux selon un plan de symétrie de la molécule favorise la croissance de gros grains monocristallins allongés orientés selon une même direction, cette direction étant celle de l'axe polaire des molécules.

Le système d'électrons π délocalisés est en particulier dû à la présence selon l'invention, d'au moins un hétéro-atome dans la chaîne carbonée du matériau organique. Ces hétéro-atomes font partie d'un cycle, aromatique ou non, ou sont liés directement au carbone d'un cycle aromatique. Comme hétéro-atomes, on peut citer l'azote, l'oxygène, le soufre ou le phosphore. Comme cycle à hétéro-atome on peut citer les cycles pyridine, furanne, pyrrole, thiophène, oxazole, pyrazine, thiazole, pyrimidine, purine, pyridazine, pipéridine, purine, pyranne, etc.

De préférence, les composés utilisables dans l'invention comportent au moins un atome d'azote ou au moins un atome d'oxygène ou les deux. A cet effet, on peut noter que les composés comportant un atome d'azote et un atome d'oxygène en position para d'un cycle benzénique, permettent d'obtenir une forte conjugaison et un important transfert de charge conférant à ces composés une non linéarité optique très élevée.

Pour être utilisés en optique non linéaire, les matériaux selon l'invention doivent présenter une grande stabilité chimique lors de l'interaction avec la lumière. A cet effet, des hétéro-atomes substitués, c'est-à-dire non liés à des hydrogènes, assurent une bonne stabilité chimique. En particulier, il est préférable d'éviter l'utilisation de composés comportant trop de liaisons N-H.

L'utilisation d'un composé dont la structure cristalline est non centro-symétrique permet d'obtenir la non linéarité du deuxième ordre. Cette structure est généralement due à la présence d'un carbone asymétrique.

Les composés organiques de l'invention doivent en outre être résistants au dommage optique afin d'éviter un changement irréversible de l'indice de réfraction.

Comme composés utilisables dans l'invention, on peut citer l'urée ; l'hexa-méthylène tétramine (HMT) ; les dérivés de la pyridine-N-oxyde tels que le 3-méthyl-4-nitropyridine-1-oxyde (POM) et le 3,5 diméthyl-4-nitropyridine-1-oxyde ; la métanitroaniline (mNA) ; les dérivés de la 4-nitroaniline tels que la 2-méthyl-4-nitroaniline (MNA), la 2-chloro-4-nitroaniline, la 2-bromo-4-nitroaniline et le diméthylamino-4-nitrobenzène ; la 4-N-diméthylaminobenzaldéhyde (AMA) ; le 2-(2,4-dinitrophényl)aminopropanoate de méthyle (MAP), le 4-N-N-diméthylamino-4′-nitrostilbène (DANS) ou encore la 4-N(nitrophényl)-2(hydroxyméthyl)pyrrolidine (NPP).

De préférence on utilise les composés dépourvus de liaison N-H tels que la HMT, le 4-nitropyridine-1-oxyde et ses dérivés, le diméthylamino-4-nitrobenzène, l'AMA, le DANS et la NPP.

Le matériau polycristallin selon l'invention peut avantageusement être utilisé dans un modulateur électrooptique en vue de moduler soit la phase, soit la polarisation d'un faisceau lumineux. A cet effet, le matériau polycristallin doit être transparent à la longueur d'onde du faisceau à moduler et les grains peuvent être orientés selon la direction de ce faisceau. En outre, deux électrodes doivent être prévues à la surface supérieure du matériau, ces électrodes étant disposées perpendiculairement aux grains monocristallins ainsi que deux polariseurs croisés.

Ce modulateur électrooptique peut être utilisé avantageusement dans une grande gamme de longueur d'onde allant de l'ultraviolet à l'infrarouge. Les applications du modulateur électrooptique selon l'invention sont nombreuses. En particulier, ce modulateur peut être utilisé lorsque :
- la polarisation ou la phase de la lumière doit être modulée,
- la puissance du faisceau à moduler est relativement élevée, ce qui est le cas pour des faisceaux laser,
- la bande passante nécessaire est supérieure à 50 MHz (domaine de la vidéo),
- la fréquence du faisceau modulé ne doit pas être translatée (la fréquence du faisceau incident est égale à la fréquence du faisceau transmis par le modulateur),
- la colinéarité du faisceau incident et du faisceau transmis est demandée,
- les diamètres des faisceaux à moduler sont importants.

D'autres caractéristiques et avantages de l'invention ressortiront mieux de la description qui va suivre, donnée à titre illustratif, et non limitatif, en référence aux figures annexées :
- la figure 1 est un diagramme donnant les différentes étapes du procédé selon l'invention,
- la figure 2 montre la courbe de décongélation commençante d'une solution aqueuse de HMT,
- la figure 3 montre une courbe de décongélation commençante d'une solution aqueuse d'urée,
- la figure 4 donne la courbe de lyophilisation de HMT,
- la figure 5 donne les variations de la pression de vapeur de HMT avec la température de séchage de la poudre,
- la figure 6 représente le moule utilisé pour le pressage de la poudre en vue de l'obtention d'un matériau polycristallin selon l'invention,
- la figure 7 est un exemple d'un matériau obtenu montrant l'orientation monodirectionnelle des grains monocristallins,
- la figure 8 montre un autre exemple de matériau obtenu selon l'invention,
- la figure 9 est le schéma de principe du dispositif servant à la détection de l'effet électrooptique dans un matériau selon l'invention, et
- la figure 10 illustre le principe de fonctionnement d'un polariseur utilisant un matériau polycristallin selon l'invention.

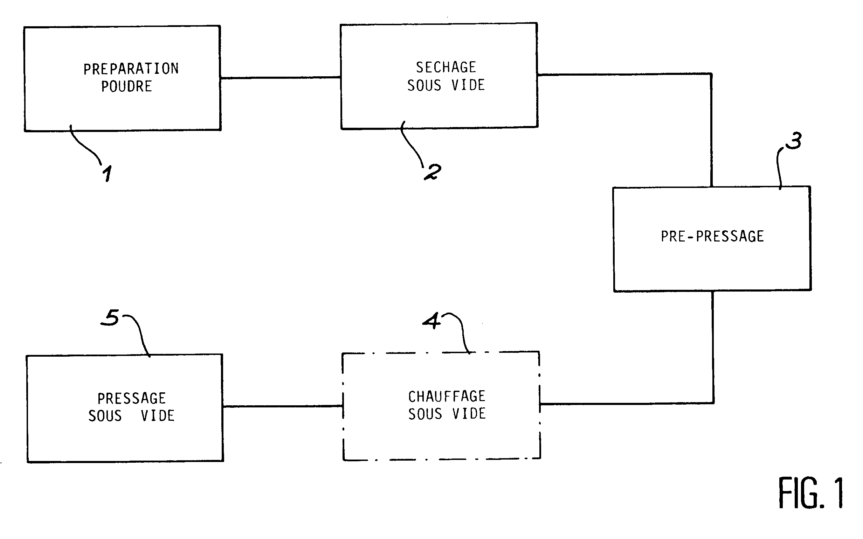

Sur la figure 1, on a représenté un diagramme donnant les différentes étapes du procédé selon l'invention.

Le procédé de l'invention comprend une étape de préparation d'une poudre fine d'un composé organique, portant la référence 1, une étape de séchage sous vide de cette poudre, portant la référence 2, une étape de pré-pressage portant la référence 3, une étape 4 de chauffage sous vide et une étape 5 de pressage uniaxial généralement à chaud, sous vide.

En vue d'une simplification, le procédé selon l'invention sera décrit pour la fabrication d'un matériau polycristallin de HMT et pour un matériau d'urée.

Pour obtenir un matériau transparent électrooptique idéal, ce matériau doit être dense, avoir un minimum de perte par transmission et un maximum de grains orientés selon une même direction. L'un des points importants est la qualité de la poudre de départ et il est illusoire de vouloir obtenir un bon matériau transparent à partir d'une poudre ne répondant pas à certains critères. Aussi, il faut une poudre :
- de grande pureté et s'efforcer de conserver cette pureté au cours des différentes opérations d'obtention du matériau polycristallin,
- dont la taille des grains est la plus faible possible, inférieure au micromètre et en particulier du même ordre de grandeur que la longueur d'onde de la radiation la mieux transmise,
- dont la distribution de la taille des grains est étroite. En effet, en dépit de certaines théories anciennes, il est intéressant d'avoir une distribution granulométrique très serrée ($D/d = 2$, où $D$ représente le diamètre maximum des grains et $d$ le diamètre moyen de ces grains) de façon à diminuer la porosité du matériau final et maîtriser la croissance des grains,

- avec des particules non agglomérées donc bien dispersées, et sèches, car l'humidité maintient un état d'agrégation qui affecte la frittabilité du matériau final, avec une distribution de la porosité non uniforme,
- des grains de la poudre équiaxes. En effet la forme tridimensionnelle des grains est importante pour un empilement futur des grains plus facile avec un simple pressage à chaud,
- avec éventuellement une morphologie facettée des grains.

Un matériau polycristallin selon l'invention, transparent dans le visible doit transmettre la lumière avec un minimum de pertes de transmission. Or, l'une des causes possibles de perte par transmission est la présence d'impuretés dans le matériau. Aussi, une pureté de 99,5% au moins est nécessaire pour le produit de départ.

Dans le tableau 1 annexé, on donne les différentes propriétés de l'HMT et de l'urée.

Dans ce tableau, $r_{41}$ représente la valeur du coefficient linéaire électro-optique (coefficient de Pockels) exprimé par une notation tensorielle réduite. Pour les détails de la définition, on peut se référer à l'article de K.D. Singer et al.

Par ailleurs, HMT se sublime à 263°C sans fusion avec une décomposition partielle. Elle est volatile à une température plus basse (pression de vapeur de 27 Pa à 100-110°C). En outre, les cristaux sont hygroscopiques. Des précautions sont donc nécessaires pour le polissage des surfaces et la conservation du matériau final. Ce matériau présente un effet électrooptique transverse aussi bien que longitudinal.

Pour l'urée, on trouve un point de fusion de 132,7°C. En outre, elle se sublime sous vide à des températures en dessous du point de fusion. Enfin, l'urée est stable à température ambiante et à la pression atmosphérique mais est peu hygroscopique et absorbe l'humidité de l'atmosphère.

## 1. OBTENTION D'UNE POUDRE FINE DU COMPOSE ORGANIQUE

Selon l'invention, la poudre fine est obtenue par atomisation (ou pulvérisation) d'une solution aqueuse ou alcoolique du composé organique, à l'aide d'une buse de 0,5 mm de diamètre et est pulvérisée dans un courant d'air chaud comprimé. Le solvant s'évapore immédiatement et enveloppe le produit de vapeur, le protégeant ainsi contre les effets d'une chaleur excessive. Le produit passe de la phase liquide à l'état solide sous forme de poudre fine et sèche, sans détérioration. L'analyse aux rayons X a permis de le confirmer.

L'atomisation est une méthode d'obtention de poudre sèche, fine, de granulométrie inférieure au micromètre et donc satisfaisante pour l'obtention du matériau polycristallin selon l'invention. La poudre obtenue est très peu polluée.

Le tableau II, annexé, donne différentes conditions opératoires pour l'atomisation.

Une autre méthode d'obtention d'une poudre selon l'invention est la lyophilisation qui comporte la mise en solution du produit organique dans un solvant aqueux ou alcoolique ; la congélation de cette solution puis sa sublimation sous vide en vue d'en éliminer le solvant.

Le solvant utilisable pour la lyophilisation doit être susceptible d'être solidifié par refroidissement et doit présenter à l'état solide une tension de vapeur suffisamment élevée pour permettre son extraction par sublimation sous un vide modéré et à une vitesse raisonnable. Bien que l'eau ne soit pas le solvant idéal pour la lyophilisation, c'est ce solvant qui a été choisi du fait de sa température de solidification relativement élevée (0°C).

La lyophilisation conduit à une poudre sèche. La teneur en solvant de la poudre est très réduite (inférieure à 0,02%) et il est préférable de l'utiliser tout de suite pour la compression.

Afin de ne pas polluer la poudre, on utilise des solvants le plus pur possible. Pour l'eau utilisée comme solvant on peut utiliser celle fournie par un ensemble de purification MilliQ vendue par la société Millipore de résistivité minimum de 18 MΩ.cm. Cette eau contient au maximum 12 ppm d'impuretés minérales.

Afin d'empêcher la séparation de la solution, durant la congélation, on utilise avantageusement une composition eutectique et on a alors une plus grande latitude dans la vitesse de refroidissement. On peut aussi effectuer une congélation très rapide avec des solutions de concentration désirées et en particulier très diluées si nécessaire.

Pour obtenir une poudre de qualité satisfaisante par lyophilisation, il faut connaître en premier lieu la température de congélation et la température de décongélation commençante de la solution organique (solvant + composé organique), température de décongélation commençante qu'il ne faut pas atteindre pour une lyophilisation correcte sans passage à l'état liquide intermédiaire. La température de sublimation est environ de 5 à 10°C inférieure à celle de la décongélation commençante.

Les températures de décongélation commençante ainsi que les concentrations des solutions à l'eutectique peuvent être déterminées par analyse thermique différentielle à basse température pour différentes concentrations du composé dans la solution. Par exemple, on peut utiliser le microanalyseur thermique différentiel Sétaram (1200 °C) adapté aux basses températures, cet appareillage étant refroidi par l'azote liquide.

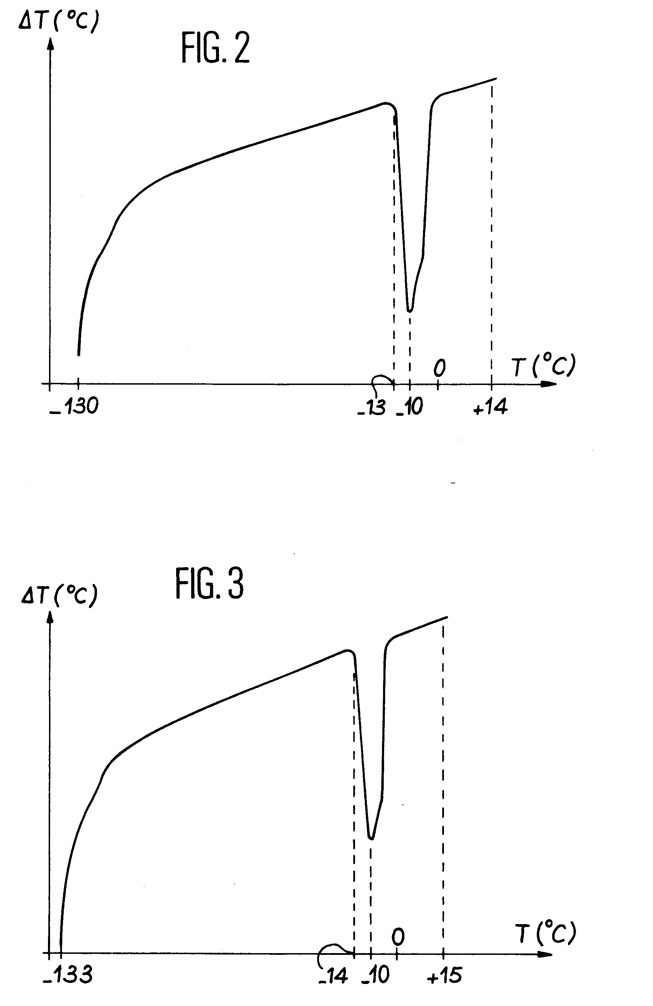

La figure 2 donne l'analyse thermique différentielle d'une solution aqueuse de 20% en poids de HMT, indiquant que la température de décongélation commençante est égale à -13 °C. Cette courbe donne en abscisses la température en °C et en ordonnées la variation en température, Δ T.

Dans les mêmes conditions, on a effectué une analyse thermique différentielle d'une solution aqueuse de 20% en poids d'urée. Cette analyse est représentée sur la figure 3. La courbe montre une température de décongélation commençante à -14 °C. La mesure de température est appréciée à plus ou moins 1 °C.

La morphologie et la taille cristalline de la poudre est figée dès la congélation et conditionne pour une grande part la conduite de la sublimation ainsi que les qualités du produit final. Une morphologie en petits cristaux équiaxes est souhaitable pour une sublimation facile et un produit final plus homogène.

La congélation peut être réalisée en vrac dans une boîte de Pétri placée dans la cuve du lyophilisateur du type RP 2V de chez Sérail.

La vitesse de congélation est celle de l'appareil et le fluide frigorigène est le fréon R502. Dans ces conditions, une heure est nécessaire pour descendre de la température ambiante à -45 °C, température suffisante pour la congélation d'une solution aqueuse de HMT et d'une solution aqueuse d'urée.

Il est aussi possible de congeler la solution par atomisation dans l'azote liquide puis transfert du produit congelé dans une boîte de Pétri, placée dans la cuve de lyophilisateur déjà portée à -45 °C. Dans ces conditions, la congélation est immédiate.

L'atomisation dans l'azote liquide est notamment décrite dans le document FR-A-2 251 535 de M. PAULUS. La buse de pulvérisation du type dispersion en cône creux présente un diamètre de 0,41 mm.

La lyophilisation se poursuit par la sublimation du solvant du composé organique. Cette sublimation est faite à une pression inférieure à la tension de vapeur du solvant, à la température de lyophilisation choisie, en tenant compte des résultats d'analyse thermique différentielle obtenus.

A tout moment, on doit rester à l'état solide et empêcher ainsi une resolvatation avec déliquescence de la poudre. Cette resolvatation doit absolument être évitée pour conserver l'homogénéité de la poudre.

Pour l'HMT et l'urée, la sublimation peut être effectuée à une température allant de -23 °C à -18 °C ; la tension de vapeur de l'eau, utilisée comme solvant, à -20 ° est de 100 Pa environ (0,8 torr). Aussi, dès que le vide dans la cuve atteint une pression supérieure à 100 Pa, la glace commence à se sublimer.

Pratiquement, on peut limiter la pression dans la cuve du lyophilisateur à 16 Pa (0,16 mbar) durant la sublimation. Un vide plus poussé n'apporte pas d'amélioration dans la vitesse d'évaporation et est plutôt un obstacle dans le transfert des calories du fond de la cuve vers le produit.

Cette pression de 16 Pa environ permet de maintenir la température du produit en-dessous de la température de décongélation et est cependant suffisamment élevée pour une vitesse d'évaporation correcte, ni trop rapide afin de ne pas entraîner la poudre trop légère à l'extérieur du lyophilisateur, ni trop lente pour une durée de lyophilisation pas trop longue.

A la fin de l'étape de sublimation, on rétablit un vide plus poussé afin de faciliter l'extraction de l'humidité résiduelle contenue dans le produit obtenu. En particulier, une pression de 5 Pa (0,05 mbar) peut être utilisée.

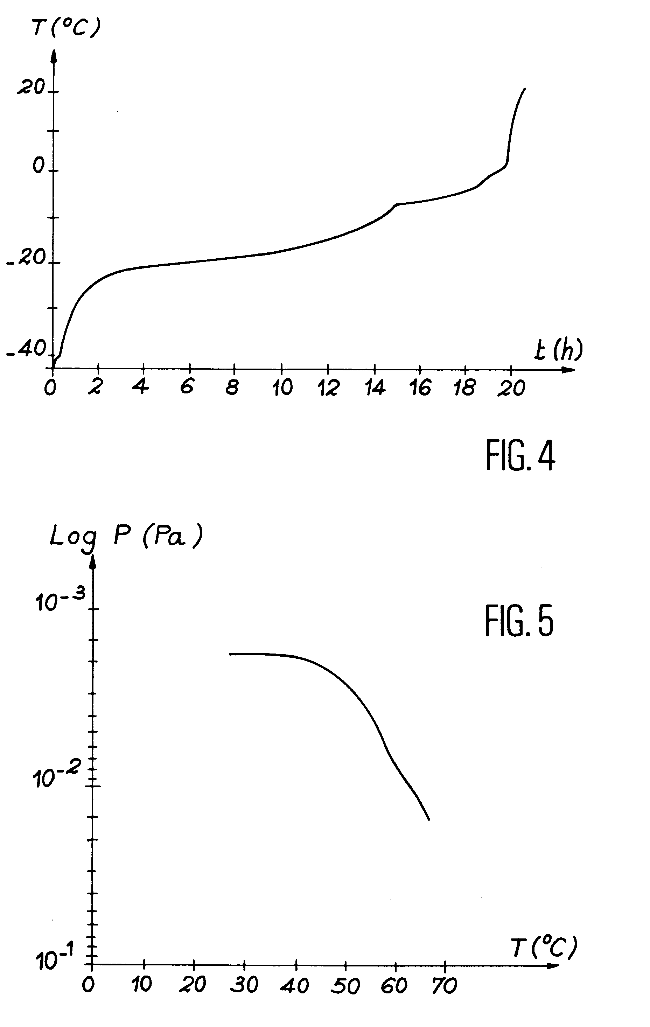

A titre d'exemple, la figure 4 présente une courbe de lyophilisation de l'HMT. Les abscisses donnent le temps t en heure et les ordonnées la température T en degré C.

La dernière étape de lyophilisation ainsi que celle de l'atomisation est l'élimination de l'eau résiduelle, c'est-à-dire des molécules d'eau retenues par absorption à l'intérieur de la poudre apparemment sèche.

Aussi, le procédé selon l'invention comporte une étape de séchage.


## 2. SECHAGE DE LA POUDRE

La température du séchage est variable avec chaque produit, en fonction de sa tension de vapeur ainsi que du degré de dessiccation désiré. Etant donné que les produits organiques présentent des tensions de vapeur importantes à des températures relativement faibles, il est nécessaire de chauffer le matériau à une température au plus égale à 60 °C.

En fonction du produit, la température maximale de séchage peut être déterminée en observant la détérioration du vide en fonction de la température dans une enceinte à vide où se trouve le moule devant servir à la fabrication du matériau solide. Le produit doit être préalablement pressé à la main pour éviter toute perte de produit au moment de la mise sous vide. Les valeurs de la pression P sont alors relevées en fonction de la température et portées sur un papier semi-logarithmique.

A titre d'exemple, la figure 5 donne les variations de la pression de vapeur de HMT pré-pressée avec la température de séchage. La pression, exprimée en Pa, est portée en ordonnée sous forme de logarithme et la température, exprimée en degrés C est portée en abscisse.

De cette courbe, il ressort que la température maximale de séchage est égale à 35°C.

Cette technique de détermination de la température maximum de séchage a été effectuée de la même façon pour l'urée et on a obtenu une valeur de 50°C.

La poudre sèche ainsi obtenue peut alors être pressée en vue de l'obtention d'un matériau polycristallin.

## 3. PRESSAGE

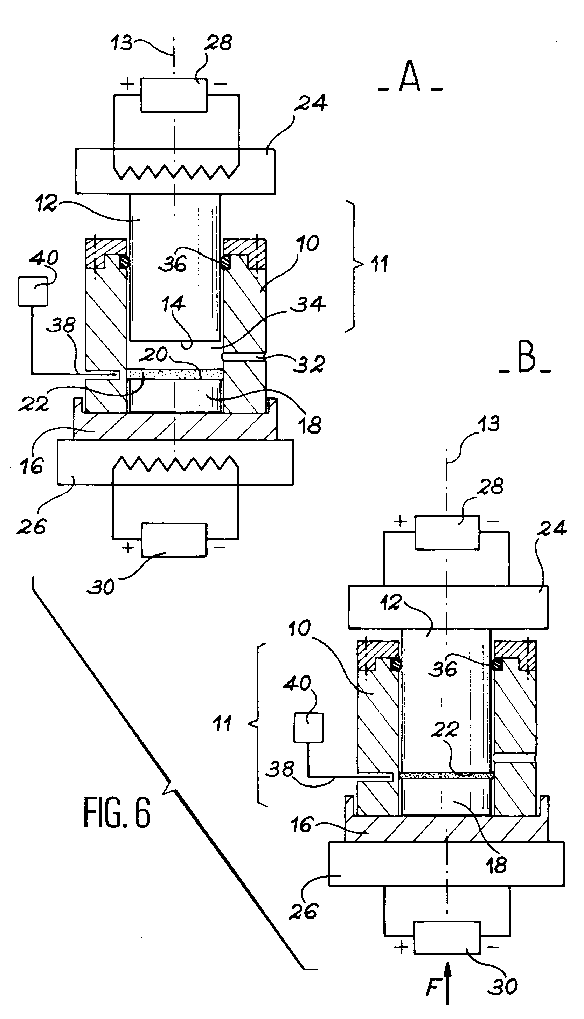

Le pressage est effectué avec le moule représenté schématiquement sur la figure 6. Ce moule 11 est réalisé en acier martensitique à durcissement structural, appelé couramment acier Maraging. Il comprend un cylindre creux 10 dans lequel peut se déplacer un piston 12 selon l'axe 13 du cylindre 10. La base 14 du piston est polie. La base du cylindre 10 s'appuie sur un socle 16. A l'intérieur du cylindre 10 et en appui sur le socle 16 se trouve un support 18 dont la face supérieure 20 est polie et est parallèle à la base 14 du piston. Le support 20 est destiné à recevoir la poudre 22 à comprimer, obtenue précédemment.

Le moule 11 est placé entre deux plateaux chauffants, un plateau fixe 24 et un plateau mobile 26, du type à résistances chauffantes, les résistances du plateau fixe étant reliées à une première source d'alimentation électrique 28, et les résistances du plateau mobile étant reliées à une seconde source d'alimentation électrique 30.

Le cylindre 10 est pourvu de plusieurs orifices 32 disposés radialement et permettant de faire le vide dans la chambre de compression 34 et dans la poudre 22 ; la chambre de compression 34 est définie par les parois internes du cylindre 10, la face 20 du support 18 et la base 14 de piston 12. Afin de maintenir la chambre 34 en dépression, un joint torique d'étanchéité 36 entourant le piston 12 est prévu à la partie supérieure du cylindre 10.

Le remplissage du moule est effectué avec un entonnoir bien sec placé au centre du moule pour une distribution régulière de la poudre.

Afin de connaître la température régnant dans la chambre de compression 34, un thermocouple 38 relié à un système électronique de mesure 40 est logé en regard du support 18.

La partie A de la figure 6 représente la position du moule lors de la mise sous vide, avant le pressage, et la partie B la position du moule au cours du pressage.

Ce dispositif du type presse uniaxiale à plateaux chauffants permet d'atteindre des températures de 250°C maximum sur les plateaux.

Les plateaux chauffants 24 et 26 sont en cuivre, la presse assurant une pression uniaxiale schématisée par la flèche F est par exemple une presse Basset. La mise sous vide de la chambre de compression 34 peut être assurée avec une pompe primaire Alcatel à deux étages ayant un débit d'air de 8 mètres cube par heure et une pompe secondaire à diffusion Edwards ayant une vitesse de pompage de 300l/seconde et un vide limite inférieur de $10^{-5}$ Pa ($10^{-7}$ torr).

Le pressage comporte tout d'abord une étape de pré-pressage à froid ou à chaud. Ce pré-préssage doit être effectué à une pression permettant de transformer la poudre en un compact mais cette pression ne doit pas être trop élevée afin de garder une porosité ouverte du compact. En effet, une porosité fermée empêche une mise sous vide supposée correcte de la poudre et une évacuation des gaz se trouvant à l'intérieur du compact. Ces gaz ne pouvant pas sortir au moment du pressage à chaud (ou frittage) laisseront des pores importants qui sont source de diffusion, et donc de non transparence du matériau final, ou encore de craquelure si les gaz arrivent à s'échapper du produit final.

Ce pré-pressage peut être effectué à une pression allant de $6,25.10^4$ à $17,5.10^5$ Pa, et en particulier égale à $12,5.10^4$ Pa. Ce pré-pressage est effectué à température ambiante pendant 15 mn sous vide secondaire de $8.10^{-5}$ Pa ($6x10^{-7}$ torr) environ.

On effectue ensuite l'étape de pressage à proprement parler. La pression uniaxiale appliquée au matériau ne doit pas dépasser la limite élastique du matériau. En outre, la vitesse de pressage doit être inférieure à 25 micromètres/s et par exemple égale à 20.

Cette étape de pressage est réalisée en principe à chaud. Toutefois, l'HMT peut être pressée à froid sous une pression de $2,4.10^7$ Pa avec un vide de 0,6 Pa ($5.10^{-2}$ torr), à condition que le diamètre de la pastille ne fasse pas plus de 13 mm.

L'étape de pressage à chaud peut être conduite de deux façons différentes.

La première façon consiste à mettre en chauffe le plateau 26 à une température supérieure à 50°C, par exemple de 60°C, le plateau 24 étant maintenu à température ambiante. Il se crée alors un gradient de température entre la base 14 du piston et le support 18. Le vide à l'intérieur de la chambre de compression 34 est maintenu à 5 Pa. Le piston 12 est maintenu en position haute comme représenté sur la partie A de la figure 6. Sous l'effet du gradient de température, la poudre se sublime et les molécules volatilisées viennent se fixer au contact du piston 12 à température plus basse que le support 18. Il se forme alors des microcristaux de l'ordre de 10 micromètres et de taille uniforme.

La croissance de microcristaux dans le moule commence naturellement à l'endroit le plus froid. Ces microcristaux servent de germes et un front continu est formé par les grains cristallins avoisinés. Graduellement, le nombre de cristaux émergeant du front décroît tandis que la surface contribuée par chaque cristal augmente.

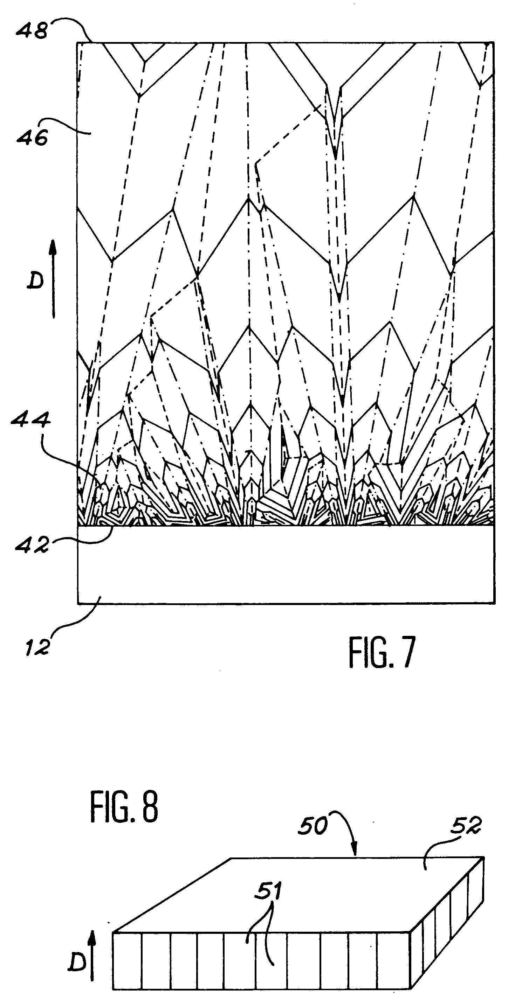

Dans cette compétition pour une place au premier rang du front, survivront en temps les cristaux orientés de telle façon que la direction la plus rapide est la normale au front d'avancement. En conséquence, après une distance parcourue, qui dépasse la distance moyenne entre les grains monocristallins ($\leq 1\mu$m), tous les cristaux développés dans le matériau présentent une forme allongée, vue en section verticale et sont quasi-parallèles les uns par rapport aux autres. Ainsi, on obtient la texture collonnaire (voir figures 7 et 8) dans une section du matériau final à condition que le gradient thermique latéral soit nul ou négligeable.

Dans cette croissance cristalline, on a constaté que plus le matériau final est épais par rapport à la taille moyenne initiale du grain élémentaire de la poudre, plus réduit sera le nombre de cristaux résultant et également leur développement plus proche de la normale au compact.

Lorsque toute la poudre est sublimée, on met alors en chauffe le plateau chauffant 24 supérieur à une température de l'ordre de 50°C. On effectue alors un pressage à 1,7 MPa pendant 15 min environ avec une fuite d'air contrôlée de $2,5.10^{-2}$ Pa entraînant la croissance des microcristaux en cristaux plus importants, transparents et monocristallins.

Un examen aux rayons X, par la méthode de Laüe a confirmé le caractère monocristallin des cristaux. En outre, un examen au microscope Zeiss, en transparence et en lumière polarisée a permis de voir l'extinction de ces cristaux.

Sur la figure 7, on a représenté le matériau polycristallin obtenu. La face inférieure 42 du matériau polycristallin qui correspond à celle en contact avec le piston 12 comporte des grains monocristallins 44 beaucoup plus petits que les grains 46 situés à la face supérieure 48 du matériau polycristallin obtenu. Ce sont ces petits grains 44 qui ont servi de germe à la croissance des monocristaux 46.

Conformément à l'invention, les grains monocristallins 46 du matériau sont orientés suivant une même direction D perpendiculaire à la surface du piston 12. Afin d'éliminer la partie inférieure du matériau polycristallin, on effectue un usinage puis un polissage optique. De même, la face supérieure du matériau subit un polissage optique.

Conformément à l'invention, il est possible de supprimer l'étape de sublimation et donc de comprimer directement la poudre 22 à chaud et sous vide.

La compacité des matériaux polycristallins obtenus a été mesurée par la méthode géométrique, méthode non destructive. La compacité des produits obtenus varie de 98,3 à 99,2 et la densité maximale atteinte est de 1,318, ce qui est relativement proche de la densité d'un matériau monocristallin. Par ailleurs, la transparence de ces matériaux a été mesurée par une méthode de transmission de la lumière et par spectrophotométrie.

Les résultats sont portés dans le tableau III annexé, donnant les conditions de pressage à chaud de la poudre d'HMT, sa densité optique D.opt et son coefficient de transmission T% pour différentes longueurs d'onde dans le visible.

L'échantillon 3 qui a été traité de la même façon que l'échantillon 2, à l'exception du fait que le pressage à chaud a été effectué 72 heures après la formation de la poudre, présente des coefficients de transmission plus failes que ceux de l'échantillon 2. Ceci est lié au fait que l'HMT est hygroscopique et que sa transparence ne se conserve pas indéfiniment. Aussi, pour obtenir un matériau polycristallin selon l'invention en HMT, l'étape de pressage doit être effectuée consécutivement à la formation de la poudre.

En outre, pour conserver cette transparence, il est souhaitable de protéger le matériau polycristallin obtenu immédiatement après son élaboration. Ceci peut être réalisé à l'aide d'un encapsulant dans lequel l'HMT n'est pas dissous et qui n'atténue pas la transparence du matériau polycristallin. A titre d'exemple, on peut citer le vernis de protection KF1280 de Siceront qui est un vernis à base d'éther de pétrole.

Les échantillons 1 à 4 du tableau III sont relatifs à des matériaux polycristallins d'HMT de 13 millimètres de diamètre et de 0,580 mm d'épaisseur.

Avec le procédé décrit précédemment, on a aussi réalisé des pastilles de 25 mm de diamètre ayant une épaisseur de 543 micromètres. Les conditions de pressage et la transparence du produit obtenu ainsi que la densité optique pour différentes longueurs d'ondes sont portées à la dernière ligne du tableau III.

A la différence d'HMT, le pressage à froid sous vide d'urée est insuffisant pour l'obtention de matériau polycristallin transparent selon l'invention. Aussi, un pressage à chaud, éventuellement précédé d'un pré-pressage à chaud sous vide est nécessaire.

Différentes conditions de pressage à chaud d'une poudre d'urée ont été réalisées et les résultats sont portés dans le tableau IV annexé. La dernière ligne du tableau donne à titre de comparaison le pourcentage de transmission d'une pastille de PLZT. A noter que le coefficient de transmission est plus élevé pour cette dernière. Ceci est certainement dû à un chauffage trop élevé pendant le pressage et à la plus faible épaisseur de la pastille de PLZT utilisée.

La densité optique moyenne obtenue pour l'échantillon 7 est de 2,62, pouvant aller jusqu'à 2,66.

Le tableau IV a été établi pour des pastilles de 18 mm de diamètre d'urée ayant subi un pré-pressage à 12,5.10$^4$ Pa sous vide primaire (5x10$^{-3}$ Pa), à une température de 50-60°C.

Avec le procédé selon l'invention, il a été possible d'obtenir un matériau polycristallin 50 d'HMT à structure collonnaire, ayant une épaisseur de 580 micromètres, comme représenté sur la figure 8. Les grains monocristallins 51 orientés perpendiculairement à la plus grande surface 52 du matériau (selon la direction D) présentent une longueur égale à l'épaisseur du matériau polycristallin.

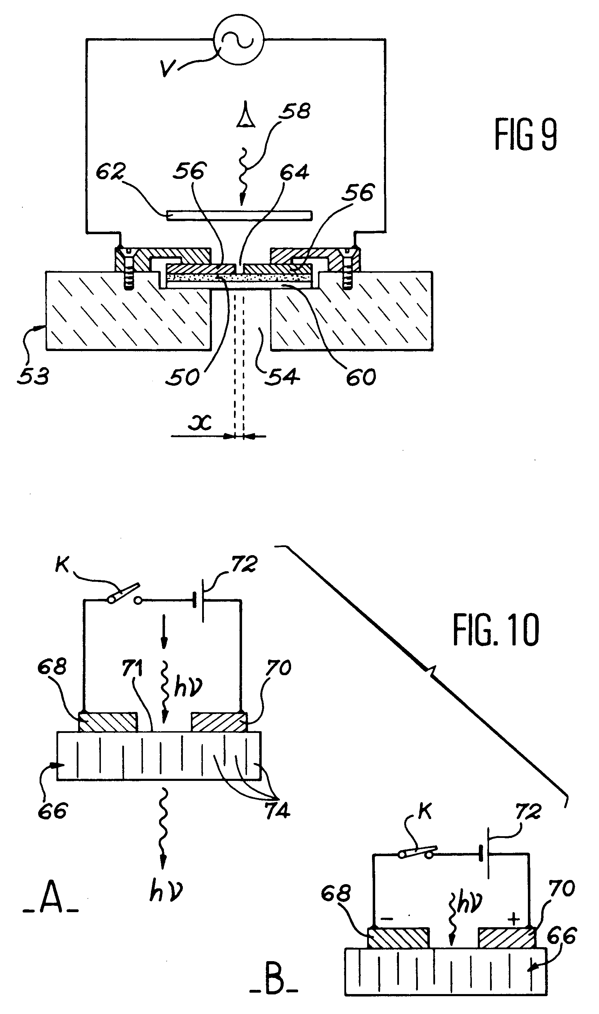

La mise en évidence de l'effet électrooptique des matériaux polycristallins selon l'invention a été détectée et visualisée à l'aide du dispositif représenté sur la figure 9. Le matériau polycristallin 50 selon l'invention, de 580 micromètres d'épaisseur environ, est placé sur un porte-échantillons en verre 53 comportant une ouverture 54 en regard du matériau 50 à analyser. Deux électrodes 56 sont collées sur la face supérieure du matériau 50 et séparées d'une distance x de 0,5 mm. Ces deux électrodes 56 sont parallèles entre elles et réalisées en cuivre. Le porte-échantillons et le matériau 50 sont regardés sous un microscope optique (Zeiss Universal) le vecteur polarisation de la lumière, représenté par la flèche 58, et le champ électrique créé entre les deux électrodes 56 sont parallèles. La tension est appliquée, à l'aide d'une source d'alimentation électrique 59 alternative, à un kHz pendant l'observation au microscope.

Après l'extinction entre deux polariseurs croisés 60 et 62, la transparence à travers le matériau 50 est observable à partir d'une tension seuil. Les valeurs de tension seuil trouvées pour un matériau selon l'invention en HMT varient de 900 à 1100 volts. Ces tensions seuil ont été comparées avec celles obtenues pour des échantillons de PLZT, ce dernier avait, pour une épaisseur équivalente, des tensions seuil variant de 2300 à 2900V.

Ces différences de tension de seuil sont dues au fait que les électrodes 56 étaient simplement collées sur le matériau polycristallin de l'invention (d'où un mauvais contact électrique et colle mauvaise conductrice de l'électricité) alors que les électrodes du PLZT étaient des électrodes en or évaporé. En conséquence, la valeur de la tension de seuil mesurée sur l'HMT peut être améliorée de façon considérable en réalisant en particulier un modulateur électrooptique à électrodes en or évaporé.

Quoi qu'il en soit, suite à l'application de la tension de seuil, le matériau 50 selon l'invention est devenu transparent dans la région 64 située entre les deux électrodes 56.

Dans ces conditions expérimentales, on a trouvé une variation d'indice de réfraction pour HMT induite électrooptiquement de 6,4.10$^{-6}$ et de 5,4.10$^{-6}$ pour l'urée. Ces changements d'indice de réfraction notés dn introduisent un décalage de phase p de la lumière traversant le matériau polycristallin donné par l'équation $p = (2\pi/l).dn.e$, où dn représente la différence d'indice induite électrooptiquement, l la longueur d'onde de la lumière transmise et, e l'épaisseur du matériau polycristallin.

Dans ces conditions, pour une longueur d'onde de 600 nanomètres, on trouve un déphasage de 4,02.10$^{-5}$ pour HMT et de 3,39.10$^{-5}$ pour l'urée.

Le matériau selon l'invention peut alors être utilisé comme modulateur électrooptique et en particulier comme polariseur dont le fonctionnement est schématisé sur la figure 10.

Un matériau selon l'invention 66 est équipé de deux électrodes 68 et 70 en or évaporé sur l'une des faces 71 du matériau. Ces électrodes sont reliées à une source d'alimentation électrique continue 72. Un interrupteur K permet de fermer ou d'ouvrir le circuit électrique.

Lorsque le circuit est ouvert, partie A de la figure 10, la lumière (h$\nu$), arrivant sur la face supérieure 71 du matériau et orientée parallèlement aux grains monocristallins 74 du matériau selon l'invention, est transmise et ressort par la face inférieure du matériau. Lorsque le cicuit électrique est fermé, partie B de la figure 10, le faisceau lumineux incident (h$\nu$) arrivant parallèlement aux grains monocristallins 74 du matériau est absorbé par le matériau donc, non transmis.

A titre d'exemple, on donne ci-après trois exemples d'obtention d'une pastille transparente d'HMT et d'urée de 13 mm de diamètre et de 580 micromètres d'épaisseur.

EXEMPLE 1

Une solution aqueuse de 20% en poids d'HMT est préparée à partir d'une eau provenant d'un ensemble Millipore (modèle MilliQ) et d'HMT commercialisé par Merck de pureté minimum de 99,5%. La solution obtenue est congelée en vrac dans une boîte de Pétri à fond plat dans un lyophilisateur commercialisé par Sérail, à -44°C pendant 4 heures. La pression est alors abaissée à 20 Pa (0,2 mb) et la température est ramenée à -20°C afin de réaliser la lyophilisation.

Après une dessiccation sous un vide de 50 Pa (0,5 mb) pendant une journée environ, la poudre est retirée du lyophilisateur, la température finale étant de 20°C et la pression de 50 Pa. La poudre fraîchement obtenue est alors écrasée dans un mortier puis introduite dans le moule de pressage 11 (figure 6) de diamètre 13 mm intérieur et donc égal au diamètre de la future pastille.

Cette poudre est maintenue dans un vide primaire ($6 \times 10^{-3}$ Pa) pendant 3 à 4 heures dans le moule de pressage à la température ambiante (20°C). Une pression uniaxiale de $2,4.10^7$ Pa (d'après la lecture du manomètre) est appliquée au moyen d'une presse Perkin-Elmer pendant 15 minutes.

La transparence de la pastille obtenue a été constatée par contrôle visuel et mesurée en transmission par la technique de spectrophotométrie VIS/IR. La valeur la plus élevée obtenue, après la correction d'atténuation par multiples réflexions à l'interface HMT-air est de 95%.

Une distribution bi-modale des grains monocristallins a été constatée. Les grains de diamètre sous-micronique ont été déterminés par une technique utilisant la diffusion Rayleigh de la lumière et les grains de dimension supra-micronique ont été déterminés par diffusion de rayons X. Les grains monocristallins avaient une dimension allant de 800 à 5000 nm.

EXEMPLE 2

Une solution aqueuse de HMT est préparée dans les mêmes conditions que dans l'exemple 1. Cette solution est alors atomisée avec un atomiseur de laboratoire, Büchi (avec une buse de 0,5 mm de diamètre). La température d'entrée du gaz d'atomisation est maintenue à 116°C et celle de sortie à 74°C avec un débit d'air comprimé de 500 à 600 litres par heure. La poudre fraîchement obtenue est alors écrasée dans un mortier puis introduite dans le même moule de pressage que dans l'exemple 1. Cette poudre est maintenue sous vide primaire pendant 3 à 4 heures à température ambiante. Une pression uniaxiale de $2,4.10^7$ Pa est alors appliquée pendant 15 minutes. La transparence a été constatée comme dans l'exemple 1.

Le rendement obtenu est de 40%.

EXEMPLE 3

Une solution aqueuse de 4% d'urée Aristar BDH d'une pureté de 99,9% est préparée à partir d'une eau provenant de l'ensemble Millipore ci-dessus. La solution obtenue est congelée par atomisation dans l'azote liquide à travers une buse Emani avec une pression d'azote de $6.10^5$ Pa (6 bars). La solution congelée est recueillie dans une boîte de Pétri placée dans la cuve d'un lyophilisateur Serail refroidi à -46°C. La congélation est effectuée pendant 3 à 4 heures.

On effectue ensuite un vide primaire de $2.10^{-3}$ Pa pendant 25 minutes. La lyophilisation se poursuit sous un vide réduit de 16 à 17 Pa jusqu'à la température ambiante de 20°C. On effectue alors un séchage sous vide à 4,5 Pa pendant une journée, sans chauffage puis avec un chauffage progressif jusqu'à 30°C environ.

La poudre fraîchement obtenue est alors écrasée dans un mortier puis introduite dans un moule de pressage comme décrit précédemment. Après une dessiccation à 47°C sous vide primaire avec une fuite contrôlée de $2,5.10^{-2}$ Pa pendant 3 heures (temps nécessaire pour augmenter la température), on a effectué un pré-pressage de 0,1 tonne sous vide primaire pendant 10 minutes à une température de 20°C puis un pressage uniaxial de $2,4.10^7$ Pa pendant 15 minutes à 50°C et sous une pression de $17.10^5$ Pa. La transparence a été constatée par contrôle visuel et mesurée en transmission par la technique de spectrophotométrie VIS/IR.

La valeur la plus élevée obtenue pour la transmission, après la correction d'atténuation par les multiples réflexions d'interface urée-air, était de 51%.

TABLEAU I

|  | HMT | UREE |
|---|---|---|
| Groupe spatial des cristaux | $\bar{I}43\,m$ | $\bar{4}2\,m$ |
| maille | cubique à corps centré $a_0 = 0{,}7021$ nm | quadratique $a_0 = 0{,}5645$ nm $c_0 = 0{,}4704$ nm |
| densité à 20°C | 1,33 | 1,323 |
| transparence | 300-2200 nm | 210-1400 nm |
| indice de réfraction | 1,5936 à 25°C pour $\lambda = 633$ nm | 1,484 à 20°C |
| $r_{41}$ (expérimental) | $0{,}72 \times 10^{-12}$ mV$^{-1}$ | $1{,}86 \times 10^{-12}$ mV$^{-1}$ |

TABLEAU II

| Conditions opératoires pour l'atomisation | | | | | |
|---|---|---|---|---|---|
| Echantillon | T° d'entrée (°C) | T° de sortie (°C) | débit d'air comprimé (l/h) | temps d'atomisation | rendement d'atomisation (%) |
| HMT solution aqueuse (10%) | 116 | 74 | 500-600 |  |  |
| HMT solution alcoolique (2% éthanol) | 70 | 56 | 500 | 16 min | 21 |
| HMT solution alcoolique (2% éthanol) | 62-64 | 54-50 | 500 | 50 min | 28 |
| Urée solution aqueuse (10%) | 148 | 100 | 600 | 8 min 30 s | 30 à 40 * |

(* le rendement de 40% tient compte de la poudre récupérée dans le cyclone).

TABLEAU III

PRESSAGE DE HMT

| ECHANTILLON HMT | CONDITIONS PRESSAGE PRESSE PERKIN-ELMER VIDE (Pa) | TRANSMISSION EN FONCTION DE LA LONGUEUR D'ONDE | | | | | |
|---|---|---|---|---|---|---|---|
| | | 400 nm D.opt T% | 480 nm D.opt T% | 560 nm D.opt T% | 650 nm D.opt T% | 750 nm D.opt T% | 800 nm D.opt T% |
| 1 —(13 mm) | poudre séchée plaque chauffante séchage : Vide primaire 6,5 pressage :15MPa 15 min + vide : 6,5 | 0,39/ 40,73 | 0,31/ 49,1 | 0,27/ 53,76 | 0,235/ 58,14 | 0,205/ 62,34 | 0,185/ 65,36 |
| 2 (13 mm) | poudre fraîchement sortie séchage : Vide primaire 6,5 5 h pressage :12,5MPa 15min + vide : 8 | | 0,255/ 55,86 | | 0,25/ 56,18 | | 0,24/ 57,8 |
| 3 (13 mm) | même pastille que 2 (72h après pressage) | | 0,355/ 44,25 | | 0,36/ 43,67 | | 0,36/ 43,67 |
| 4 (13 mm) | poudre fraîchement sortie séchage : Vide primaire 6,5 4h pressage :12,5MPa 15min + vide : 6,5 | 0,2725/ 53,39 | 0,217/ 60,64 | 0,175/ 66,8 | 0,1425/ 72,04 | 0,1125/ 77,22 | 0,1/ 79,43 |
| 5 (25 mm) | poudre fraîchement sortie séchage : vide primaire 2 x10$^{-3}$ 5h pressage 15 MPa + vide 6,5 | | 0,43/ 37,17 | 0,36/ 43,67 | 0,30/ 50,25 | 0,25/ 56,18 | 0,23/ 58,82 |

EP 0 333 573 B1

TABLEAU IV

| Echantillon UREE | Traitements subis | | vide (Pa) | épaisseur (en mm) | % transmission | | |
|---|---|---|---|---|---|---|---|
| | T° (°C) | pression | | | Moy. | Max. | Min. |
| 6 | 60 | 5T 15 min | $4.10^{-3}$ | 0,580 | 49 | 51 | 46 |
| 7 | 60 | 5T 1h | $8,6.10^{-3}$ | 0,580 | 49 | 51 | 47 |
| 8 | 90 | 5T 15 min | $8,9.10^{-3}$ | 0,580 | 47 | 49 | 44 |
| 9 | 60 | 5T 3/4h | $7,9.10^{-2}$ | 0,290 | 35 | 45 | 32 |
| C | | | | 0,205 | 72 | 72 | 72 |

## Revendications

1. Procédé d'obtention d'un matériau polycristallin (50, 66) comportant des grains monocristallins (51, 74), orientés selon une même direction, ce matériau étant formé d'un composé organique moléculaire dont les molécules présentent au moins un dipôle, ce procédé comprenant les étapes suivantes :

   a) - choix d'un composé organique dont les molécules présentent au moins un axe de symétrie parallèle au dipôle,

   b) - préparation (1) d'une poudre fine dudit composé ayant une granulométrie inférieure au micromètre,

   c) - séchage (2) sous vide de la poudre à une température inférieure à la température à laquelle la tension de vapeur dudit composé induit une détérioration sensible dudit vide,

   d) - compression (5) selon cette direction, sous vide, de la poudre sèche pour former des grains monocristallins allongés où le ou les dipôles de leurs molécules sont orientés selon ladite direction.

2. Procédé d'obtention selon la revendication 1, caractérisé en ce qu'il comprend une étape de chauffage (4) sous vide de la poudre sèche intervenant soit avant, soit pendant l'étape de compression (5).

3. Procédé d'obtention selon la revendication 2, caractérisé en ce que l'étape de chauffage (4) et l'étape de compression (5) sont réalisées simultanément.

4. Procédé d'obtention selon l'une quelconque des revendications 1 à 3, caractérisé en ce que l'étape d) est précédée d'une étape de pré-compression (3) sous vide.

5. Procédé d'obtention selon l'une quelconque des revendications 1 à 4, caractérisé en ce que la poudre est formée par atomisation ou lyophilisation.

6. Procédé d'obtention selon la revendication 5, caractérisé en ce que l'étape b) consiste à dissoudre le composé organique dans un solvant polaire pour former une solution et pulvériser cette solution pour obtenir des gouttes de 0,5 à 2 micromètres de diamètre.

7. Procédé d'obtention selon la revendication 6, caractérisé en ce que le solvant est un solvant organique.

8. Procédé d'obtention selon la revendication 6 ou 7, caractérisé en ce que la lyophilisation comprend une étape de congélation de la solution pulvérisée dans l'azote liquide.

9. Procédé d'obtention selon l'une quelconque des revendications 6 à 8, caractérisé en ce que la solution contient de 2 à 40% en poids du composé.

10. Procédé d'obtention selon l'une quelconque des revendications 1 à 9, caractérisé en ce que la poudre présente une granulométrie de 500 à 800 nm.

11. Matériau polycristallin, comportant des grains monocristallins (51, 74) orientés selon une même direction (D), ce matériau étant formé d'un composé organique moléculaire dont les molécules présentent au moins un axe de symétrie selon cette direction et au moins un dipôle orienté selon cet axe.

**12.** Matériau polycristallin selon la revendication 11, caractérisé en ce que le matériau présente des propriétés de propagation non linéaire de la lumière.

**13.** Matériau polycristallin selon la revendication 12, caractérisé en ce que le composé organique comporte un système d'électrons $\pi$ délocalisés et en ce que le matériau présente une structure cristalline non centrosymétrique.

**14.** Matériau polycristallin selon la revendication 13, caractérisé en ce que le composé comporte des groupements à transfert de charges intra-moléculaires.

**15.** Matériau polycristallin selon l'une quelconque des revendications 12 à 14, caractérisé en ce que le composé comporte au moins un hétéro-atome.

**16.** Matériau polycristallin selon la revendication 15, caractérisé en ce que l'hétéro-atome est choisi parmi l'azote et l'oxygène.

**17.** Matériau polycristallin selon la revendication 16, caractérisé en ce que l'hétéro-atome fait partie d'une chaîne cyclique.

**18.** Matériau polycristallin selon l'une quelconque des revendications 15 à 17, caractérisé en ce que l'hétéro-atome est substitué.

**19.** Matériau polycristallin selon la revendication 12 ou 13, caractérisé en ce que le composé est choisi parmi l'urée, l'hexaméthylène tétramine, les dérivés de la pyridine-1-oxyde, la NPP, les dérivés de la 4-nitroaniline, la 4-N-diméthylaminobenzaldéhyde.

**20.** Modulateur électrooptique servant à moduler un faisceau lumineux d'une longueur d'onde déterminée, caractérisé en ce qu'il comprend un matériau polycristallin (66) selon l'une quelconque des revendications 12 à 19, transparent à ladite longueur d'onde, entre deux polariseurs croisés (60, 62), et deux électrodes (68, 70) disposées sur le matériau perpendiculairement aux grains.

**21.** Modulateur électrooptique selon la revendication 20, caractérisé en ce que la plus petite dimension des grains (74) est au moins égale à ladite longueur d'onde.

**Claims**

**1.** Process for obtaining a polycrystalline material (50, 66) having monocrystalline grains (51, 74) oriented in the same direction, said material being formed from a molecular organic compound, whose molecules have at least one dipole, said process comprising the following stages:
    a) choice of an organic compound, whose molecules have at least one axis of symmetry parallel to the dipole,
    b) preparation (1) of a fine powder of said compound having a grain size below 1 micrometre,
    c) vacuum drying (2) of the powder at a temperature below that at which the vapour tension of said compound leads to a significant deterioration of said vacuum,
    d) vacuum compression (5) in said direction of the dry powder in order to form elongated monocrystalline grains, where the dipole or dipoles of their molecules are oriented in said direction.

**2.** Process according to claim 1, characterized in that it comprises a vacuum heating stage (4) of said dry powder occurring either before, or during the compression stage (5).

**3.** Process according to claim 2, characterized in that the heating stage (4) and the compression stage (5) are performed simultaneously.

**4.** Process according to any one of the claims 1 to 3, characterized in that the stage d) is preceded by a vacuum precompression stage (3).

16

5. Process according to any one of the claims 1 to 4, characterized in that the powder is formed by atomization or lyophilization.

6. Process according to claim 5, characterized in that stage b) consists of dissolving the organic compound in a polar solvent in order to form a solution and atomize said solution in order to obtain diameter 0.5 to 2 micrometre drops.

7. Process according to claim 6, characterized in that the solvent is an organic solvent.

8. Process according to claim 6 or 7, characterized in that the lyophilization comprises a stage of freezing the atomized solution in liquid nitrogen.

9. Process according to any one of the claims 6 to 8, characterized in that the solution contains 2 to 40% by weight of the compound.

10. Process according to any one of the claims 1 to 9, characterized in that the powder has a grain size from 500 to 800 nm.

11. Polycrystalline material having monocrystalline grains (51, 74) oriented in the same direction (D), said material being formed from a molecular organic compound, whose molecules have at least one axis of symmetry in said direction and at least one dipole oriented according to said axis.

12. Polycrystalline material according to claim 11, characterized in that the material has non-linear light propagation properties.

13. Polycrystalline material according to claim 12, characterized in that the organic compound incorporates a delocalized $\pi$ electron system and in that the material has a non-centrosymmetric crystalline structure.

14. Polycrystalline material according to claim 13, characterized in that the compound has intra-molecular charge transfer groups.

15. Polycrystalline material according to any one of the claims 12 to 14, characterized in that the compound has at least one heteroatom.

16. Polycrystalline material according to claim 15, characterized in that the heteroatom is chose from among nitrogen and oxygen.

17. Polycrystalline material according to claim 16, characterized in that the heteroatom forms part of a cyclic chain.

18. Polycrystalline material according to any one of the claims 15 to 17, characterized in that the heteroatom is substituted.

19. Polycrystalline material according to claim 12 or 13, characterized in that the compound is chosen from among urea, hexamethylene tetramine, derivatives of pyridine-1-oxide, NPP, derivatives of 4-nitroaniline and 4-N-dimethylaminobenzaldehdyde.

20. Electro-optical modulator for modulating a light beam having a given wavelength, characterized in that it comprises a polycrystalline material (66) according to any one of the claims 12 to 19, which is transparent to said wavelength, between two cross polarizers (60, 62), and two electrodes (68, 70) disposed on said material perpendicular to the grains.

21. Electro-optical modulator according to claim 20, characterized in that the smallest dimension of the grains (74) is at least equal to said wavelength.

**Patentansprüche**

1. Verfahren zum Herstellen eines polykristallinen Materials (50, 66), welches monokristalline Körner (51, 74) umfaßt, welche nach der gleichen Richtung ausgerichtet sind, wobei das Material aus einer organischen Molekülverbindung gebildet ist, deren Moleküle mindestens einen Dipol aufweisen, wobei das Verfahren die folgenden Schritte umfaßt:
   a) Auswahl einer organischen Verbindung, deren Moleküle mindestens eine zum Dipol parallele Symmetrieachse aufweisen,
   b) Herstellung (1) eines feinen Pulvers dieser Verbindung mit einer Korngröße unterhalb von 1 $\mu$m,
   c) Trocknen (2) des Pulvers im Vakuum bei einer Temperatur unterhalb der Temperatur, bei der der Dampfdruck der Verbindung zu einer merklichen Herabsetzung des Vakuums führt,
   d) Pressen (5) des trockenen Pulvers in dieser Richtung im Vakuum, um monokristalline längliche Körner zu bilden, wobei der oder die Dipole ihrer Moleküle nach dieser Richtung ausgerichtet sind.

2. Verfahren zum Herstellen nach Anspruch 1, **dadurch gekennzeichnet**, daß es einen Erwärmungsschritt (4) des trockenen Pulvers im Vakuum umfaßt, der entweder vor oder während des Schrittes des Pressens (5) eintritt.

3. Verfahren zum Herstellen nach Anspruch 2, **dadurch gekennzeichnet**, daß der Erwärmungsschritt (4) und der Schritt des Pressens (5) gleichzeitig ausgeführt werden.

4. Verfahren zum Herstellen nach einem der Ansprüche 1 bis 3, **dadurch gekennzeichnet**, daß dem Schritt d) ein Schritt des Vorpressens (3) im Vakuum vorhergeht.

5. Verfahren zum Herstellen nach einem der Ansprüche 1 bis 4, **dadurch gekennzeichnet**, daß das Pulver durch Zerstäubung oder Lyophilisierung gebildet ist.

6. Verfahren zum Herstellen nach Anspruch 5, **dadurch gekennzeichnet**, daß der Schritt b) darin besteht, die organische Verbindung in einem polaren Lösungsmittel aufzulösen, um eine Lösung zu bilden, und diese Lösung zu zerstäuben, um Tropfen mit 0,5 bis 2 $\mu$m Durchmesser zu erhalten.

7. Verfahren zum Herstellen nach Anspruch 6, **dadurch gekennzeichnet**, daß das Lösungsmittel ein organisches Lösungsmittel ist.

8. Verfahren zum Herstellen nach Anspruch 6 oder 7, **dadurch gekennzeichnet**, daß die Lyophilisierung einen Schritt des Einfrierens der zerstäubten Lösung in flüssigem Stickstoff umfaßt.

9. Verfahren zum Herstellen nach einem der Ansprüche 6 bis 8, **dadurch gekennzeichnet**, daß die Lösung 2 bis 40 Gew.-% der Verbindung enthält.

10. Verfahren zum Herstellen nach einem der Ansprüche 1 bis 9, **dadurch gekennzeichnet**, daß das Pulver Korngrößen von 500 bis 800 nm aufweist.

11. Polykristallines Material, welches monokristalline Körner (51, 74) umfaßt, welche nach der gleichen Richtung (D) ausgerichtet sind, wobei das Material aus einer organischen Molekülverbindung gebildet ist, deren Moleküle mindestens eine Symmetrieachse in dieser Richtung und mindestens einen Dipol, der nach dieser Achse ausgerichtet ist, aufweisen.

12. Polykristallines Material nach Anspruch 11, **dadurch gekennzeichnet**, daß das Material nichtlineare Lichtleitereigenschaften aufweist.

13. Polykristallines Material nach Anspruch 12, **dadurch gekennzeichnet**, daß die organische Verbindung ein System von delokalisierten $\pi$-Elektronen aufweist, und daß das Material eine nicht zentrosymmetrische Kristallstruktur aufweist.

14. Polykristallines Material nach Anspruch 13, **dadurch gekennzeichnet**, daß die Verbindung intramolekulare Ladungstransfergruppen umfaßt.

**15.** Polykristallines Material nach einem der Ansprüche 12 bis 14, **dadurch gekennzeichnet**, daß die Verbindung mindestens ein Heteroatom umfaßt.

**16.** Polykristallines Material nach Anspruch 15, **dadurch gekennzeichnet**, daß das Heteroatom aus Stickstoff und Sauerstoff ausgewählt ist.

**17.** Polykristallines Material nach Anspruch 16, **dadurch gekennzeichnet**, daß das Heteroatom Teil einer ringförmigen Kette ist.

**18.** Polykristallines Material nach einem der Ansprüche 15 bis 17**, dadurch gekennzeichnet**, daß das Heteroatom substituiert ist.

**19.** Polykristallines Material nach Anspruch 12 oder 13, **dadurch gekennzeichnet**, daß die Verbindung ausgewählt ist aus Harnstoff, Hexamethylentetramin, den Derivaten von Pyridin-1-oxid, NPP, den Derivaten von 4-Nitroanilin, 4-N-Dimethylaminobenzaldehyd.

**20.** Elektrooptischer Modulator, welcher dazu dient, einen Lichtstrahl von einer bestimmten Wellenlänge zu modulieren, **dadurch gekennzeichnet**, daß er ein polykristallines Material (66) nach einem der Ansprüche 12 bis 19 umfaßt, welches für diese Wellenlänge durchlässig ist, zwischen zwei gekreuzten Polarisatoren (60, 62), und zwei Elektroden (68, 70), die auf dem Material senkrecht zu den Körnern angebracht sind.

**21.** Elektrooptischer Modulator nach Anspruch 20, **dadurch gekennzeichnet**, daß die geringste Abmessung der Körner (74) mindestens gleich der Wellenlänge ist.

EP 0 333 573 B1

```
┌─────────────────┐         ┌─────────────────┐
│   PREPARATION   │         │     SECHAGE     │
│     POUDRE      │─────────│    SOUS VIDE    │──────────┐
│                 │         │                 │          │
└─────────────────┘         └─────────────────┘          │
         ⌣                           ⌣                     │
         1                           2                     │
                                                    ┌──────────────┐
                                                    │              │
                                                    │  PRE-PRESSAGE│
                                                 3  │              │
                                                    │              │
                                                    └──────────────┘
                                                           │
    5                            4                         │
┌─────────────────┐    ┌ ─ ─ ─ ─ ─ ─ ─ ─ ┐               │
│     PRESSAGE    │    │    CHAUFFAGE    │               │
│    SOUS VIDE    │────    SOUS VIDE     ────────────────┘
│                 │    │                 │
└─────────────────┘    └ ─ ─ ─ ─ ─ ─ ─ ─ ┘
```

FIG. 1

FIG. 2

FIG. 3

FIG. 4

FIG. 5

FIG. 6

_ A _

_ B _

FIG. 7

FIG. 8

FIG 9

FIG. 10

_A_

_B_